# FASCICULE DE BREVET EUROPEEN

(11) **EP 2 913 849 B1**
(45) Date de publication et mention de la délivrance du brevet: **30.11.2016**
(21) Numéro de dépôt: 15156768.2
(22) Date de dépôt: 26.02.2015
(51) Int. Cl.: H01L 21/8252, H01L 27/02, H01L 29/778, H01L 27/06, H03K 17/00, H01L 29/20, H03K 17/30

(54) **Dispositif electronique avec transistor hemt polarisé en inverse**
Elektronische Vorrichtung mit in Gegenrichtung vorgespanntem HEMT-Transistor
Electronic device with reverse-polarised HEMT transistor

(30) Priorité: 27.02.2014 FR 1451600
(43) Date de publication de la demande: 02.09.2015
(73) Titulaire: Commissariat à l'Énergie Atomique et aux Énergies Alternatives, 75015 Paris (FR); Alcatel Lucent, S.A., 75007 Paris (FR)
(72) Inventeur: Escoffier, René, 38500 LA BUISSE (FR)
(74) Mandataire: Brevalex

(56) Documents cités:
- WO-A1-2011/067903
- JP-A- H01 137 827
- JP-A- 2011 151 528
- US-A1- 2006 175 633
- US-A1- 2009 072 269
- US-A1- 2012 200 339
- US-A1- 2013 325 380

## Description

### DOMAINE TECHNIQUE ET ART ANTÉRIEUR

L'invention concerne le domaine des composants microélectroniques, et plus particulièrement un dispositif électronique ayant un comportement analogue à celui d'une diode Zener au moins lorsque celle-ci est polarisée en inverse. Un tel dispositif électronique est avantageusement utilisé pour réguler une tension électrique dans un circuit électronique, servir de référence de tension, protéger des circuits électroniques, ou encore permettre de réaliser un moniteur de tension. L'invention concerne également un procédé de contrôle du passage d'un courant électrique dans une liaison électrique via l'utilisation d'un transistor HEMT polarisé en inverse.

Contrairement à une diode conventionnelle qui n'est passante que lorsqu'elle est polarisée en directe (V_{anode} - V_{cathode} > 0), c'est-à-dire qui ne laisse passer un courant électrique que dans un seul sens, le sens direct (de l'anode vers la cathode de la diode), une diode Zener polarisée en inverse (V_{cathode} - V_{anode} > 0) laisse également passer un courant électrique circulant dans le sens inverse (de la cathode vers l'anode de la diode Zener) uniquement si la tension à ses bornes (V_{cathode} - V_{anode}) est supérieure à une certaine valeur correspondant au seuil de l'effet d'avalanche de la diode Zener et qui est appelée tension Zener. De plus, étant donné que la diode Zener polarisée en inverse maintient également la tension à ses bornes à une valeur sensiblement égale à celle de la tension Zener quelque soit la valeur du courant inverse traversant la diode Zener, la diode Zener permet par exemple de réaliser facilement une régulation de tension pour des gammes de tension allant de quelques volts à plusieurs dizaines de volts avec une précision d'environ 100 mV.

Une diode Zener est formée d'une jonction PN fortement dopée et la valeur de sa tension Zener dépend de la technologie avec laquelle la diode Zener est réalisée.

Il existe des dispositifs électroniques ayant un comportement similaire à celui d'une diode Zener dont la valeur de la tension Zener serait ajustable, ou programmable. De tels dispositifs électroniques, comme par exemple le régulateur TL431/TL432, sont toutefois complexes et font appel à de nombreux composants électroniques tels que des transistors, des capacités, des résistances et des diodes.

Il existe également des dispositifs électroniques ayant un comportement similaire à celui d'une diode Zener qui serait bidirectionnelle, c'est-à-dire qui, dans le cas d'une polarisation inverse, laisserait passer le courant inverse uniquement si la tension à ses bornes (V_{cathode} - V_{anode}) est supérieure à la valeur d'une première tension Zener et, dans le cas d'une polarisation directe, laisserait passer le courant direct uniquement si la tension à ses bornes (V_{cathode} - V_{anode}) est inférieure à la valeur d'une deuxième tension Zener. De tels dispositifs électroniques ont pour inconvénients d'avoir une température de fonctionnement limitée à environ 175°C car au-delà, les valeurs des tensions Zener ne sont plus garanties du fait que ces valeurs, basées sur un phénomène d'avalanche, augmentent avec la température. Cet inconvénient se retrouve également pour les simples diodes Zener car la valeur de la tension Zener est basée sur un phénomène d'avalanche au sein de la diode.

Le document US2009/0072269 décrit un dispositif de diode comprenant un transistor ayant une grille, un drain et une source, dans lequel la grille est reliée au drain pour permettre le dispositif de fonctionner comme une diode.

Le document WO2011/067903 décrit un dispositif de commutateur à transistor, où le transistor fonctionne comme une diode.

Le document US2012/0200339 décrit un circuit à transistor qui a une même fonction que celle d'une diode Zener, de sorte que la diode Zener peut être actionnée à une vitesse élevée.

### EXPOSÉ DE L'INVENTION

Un but de la présente invention est de proposer un dispositif électronique présentant un comportement analogue à celui d'une diode Zener polarisée en inverse, c'est-à-dire qui ne soit passant que lorsque la tension à ses bornes dépasse une certaine valeur, qui ne nécessite pas de nombreux composants électroniques pour sa réalisation, et qui puisse être utilisé pour des gammes de températures de fonctionnement supérieures à celles des dispositifs de l'art antérieur.

Pour cela, il est proposé un dispositif électronique comportant au moins :
- un premier transistor HEMT,
- des moyens de polarisation aptes à polariser au moins en inverse le premier transistor HEMT en appliquant une tension électrique V_{SD} de valeur positive entre une source du premier transistor HEMT et un drain du premier transistor HEMT,
   et dans lequel le premier transistor HEMT est apte à être passant lorsqu'une valeur d'une tension électrique V_{GD} entre une grille du premier transistor HEMT et le drain du premier transistor HEMT est supérieure à une valeur d'une tension de seuil Vₜₕ du premier transistor HEMT.

La présente invention propose en outre un dispositif électronique comportant au moins :
- un premier transistor HEMT et un deuxième transistor HEMT,
- des moyens de polarisation aptes à polariser au moins en inverse le premier transistor HEMT en appliquant une tension électrique V_{SD} de valeur positive entre une source du premier transistor HEMT et un drain du premier transistor HEMT, dans lequel :
- le premier transistor HEMT est apte à être passant lorsqu'une valeur d'une tension électrique V_{GD} entre une grille du premier transistor HEMT et le drain du premier transistor HEMT est supérieure à une valeur d'une tension de seuil Vₜₕ du premier transistor HEMT,
- la grille du premier transistor HEMT est reliée électriquement à la source du premier transistor HEMT,
   le dispositif électronique étant configuré selon une première ou une deuxième configuration, la première configuration étant telle que :
   - une source du deuxième transistor HEMT est reliée électriquement à la source du premier transistor HEMT,
   - un drain du deuxième transistor HEMT est relié électriquement au drain du premier transistor HEMT,
   - une grille du deuxième transistor HEMT est reliée électriquement à la source du deuxième transistor HEMT par l'intermédiaire d'au moins une première résistance électrique de valeur supérieure à environ 1 MΩ et est reliée électriquement au drain du deuxième transistor HEMT par l'intermédiaire d'au moins une deuxième résistance électrique de valeur supérieure à environ 1 MΩ,
   - une valeur d'une tension de seuil Vₜₕ₂ du deuxième transistor HEMT est nulle,
   - les moyens de polarisation sont également aptes à polariser en direct le premier transistor HEMT et le deuxième transistor HEMT en appliquant une tension électrique V_{SD} de valeur négative,
      la deuxième configuration étant telle que :
      - la source du deuxième transistor HEMT est reliée électriquement au drain du premier transistor HEMT,
      - le drain du deuxième transistor HEMT est relié électriquement à la source du premier transistor HEMT,
      - la grille du deuxième transistor HEMT est reliée électriquement à la source du deuxième transistor HEMT,
      - le deuxième transistor HEMT est apte à être passant lorsque la valeur d'une tension électrique V_{GD2} entre la grille du deuxième transistor HEMT et le drain du deuxième transistor HEMT est supérieure à celle d'une tension de seuil Vₜₕ₂ du deuxième transistor HEMT.

Un tel dispositif électronique fait appel à des propriétés jusque là inutilisées d'un transistor HEMT (« High Electron Mobility Transistor », ou transistor à haute mobilité d'électrons). En effet, dans le dispositif électronique selon l'invention, contrairement à une utilisation classique du transistor HEMT qui est polarisé en direct, c'est-à-dire auquel une tension électrique V_{DS} de valeur positive est appliquée entre le drain et la source du transistor HEMT, le transistor HEMT est ici détourné de son utilisation habituelle et est polarisé en inverse, via l'application d'un tension électrique V_{SD} de valeur positive entre la source et le drain du transistor HEMT. Avec une telle polarisation en inverse du transistor HEMT, le courant circule dans le transistor HEMT de la source vers le drain, alors que dans une utilisation classique d'un tel transistor HEMT, le courant circule du drain vers la source. Or, un transistor HEMT polarisé en inverse est apte à être passant lorsque la valeur de la tension électrique V_{GD} entre la grille et le drain du transistor HEMT est supérieure à la valeur de la tension de seuil Vₜₕ du transistor HEMT. Ainsi, il est possible de définir une valeur de la tension de polarisation du transistor HEMT, appelée tension Zener, via l'ajustement de la valeur de la tension de seuil Vₜₕ du transistor HEMT et/ou de la valeur de la tension V_{GS} entre la grille et la source du transistor HEMT, au-delà de laquelle le transistor HEMT est passant et permettant le passage du courant de la source vers le drain du transistor HEMT, et en-dessous de laquelle le transistor HEMT est bloqué. Un tel dispositif électronique permet donc d'ajuster facilement la valeur de la tension à ses bornes au-delà de laquelle le courant peut traverser le dispositif électronique.

Un tel dispositif électronique présente donc un comportement analogue à celui d'une diode Zener polarisée en inverse. De plus, ce dispositif électronique ne nécessite pas de nombreux composants électroniques pour sa réalisation. Ce dispositif électronique peut en outre être utilisé pour des gammes de températures supérieures à celles des dispositifs de l'art antérieur, par exemple entre environ -40°C et +300°C, voire plus.

La grille du premier transistor HEMT est reliée électriquement à la source du premier transistor HEMT.

Dans ce cas, la grille du premier transistor HEMT peut être directement reliée électriquement à la source du premier transistor HEMT et le premier transistor HEMT peut être du type à enrichissement (ou « normally off »). Ainsi, la valeur de la tension V_{GS} entre la grille et la source du premier transistor HEMT est nulle et la valeur de la tension au-delà de laquelle le courant peut traverser le dispositif électronique peut être réglée via l'ajustement de la valeur de la tension de seuil Vₜₕ du premier transistor HEMT (du fait que le transistor HEMT est passant lorsque V_{SD} > Vₜₕ - V_{GS}).

En variante, la grille du premier transistor HEMT peut être reliée électriquement à la source du premier transistor HEMT par l'intermédiaire d'une première source de tension apte à appliquer une tension électrique V_{GS} de valeur non nulle entre la grille du premier transistor HEMT et la source du premier transistor HEMT. Dans ce cas, contrairement à une utilisation classique de la grille d'un transistor HEMT qui consiste à rendre le transistor plus ou moins passant lorsque le transistor HEMT est polarisé en direct, la grille du premier transistor HEMT est ici utilisée pour décaler la valeur de la tension à partir de laquelle le premier transistor HEMT, et donc également le dispositif électronique, passera d'un état totalement bloqué à un état de conduction avec une très faible résistivité. Ainsi, la valeur de la tension au-delà de laquelle le courant peut traverser le dispositif électronique peut être réglée via l'ajustement de la valeur de la tension de seuil Vₜₕ du premier transistor HEMT et/ou via l'ajustement *a posteriori* de la valeur de la tension V_{GS} délivrée par la première source de tension. Cette variante permet de réaliser un dispositif électronique dont le comportement correspond à celui d'une diode Zener programmable.

Le dispositif électronique peut comporter en outre un deuxième transistor HEMT tel que :
- une source du deuxième transistor HEMT est reliée électriquement à la source du premier transistor HEMT,
- un drain du deuxième transistor HEMT est relié électriquement au drain du premier transistor HEMT,
- une grille du deuxième transistor HEMT est reliée électriquement à la source du deuxième transistor HEMT par l'intermédiaire d'au moins une première résistance électrique de valeur supérieure à environ 1 MΩ et est reliée électriquement au drain du deuxième transistor HEMT par l'intermédiaire d'au moins une deuxième résistance électrique de valeur supérieure à environ 1 MΩ,
- une valeur d'une tension de seuil Vₜₕ₂ du deuxième transistor HEMT est nulle,
   et les moyens de polarisation peuvent également être aptes à polariser en direct le premier transistor HEMT et le deuxième transistor HEMT en appliquant une tension électrique V_{SD} de valeur négative. Un tel dispositif électronique a pour avantage, lors d'une polarisation directe, d'avoir un comportement similaire à celui d'une diode Zener polarisée en direct, en plus du comportement de la diode Zener polarisée en inverse dont la valeur de la tension Zener est programmable.

Le dispositif électronique peut comporter en outre un deuxième transistor HEMT tel que :
- une source du deuxième transistor HEMT est reliée électriquement au drain du premier transistor HEMT,
- un drain du deuxième transistor HEMT est relié électriquement à la source du premier transistor HEMT,
- une grille du deuxième transistor HEMT est reliée électriquement à la source du deuxième transistor HEMT,
   et le deuxième transistor HEMT peut être apte à être passant lorsque la valeur d'une tension électrique V_{GD2} entre la grille du deuxième transistor HEMT et le drain du deuxième transistor HEMT est supérieure à celle d'une tension de seuil Vₜₕ₂ du deuxième transistor HEMT. Un tel dispositif électronique a pour avantage d'avoir un comportement similaire à celui d'une diode Zener bidirectionnelle, c'est-à-dire qui, en polarisation inverse, est passant lorsque la tension V_{SD} est supérieure à la valeur d'une première tension Zener, et qui est également passant, en polarisation directe, lorsque cette tension V_{SD} est inférieure à la valeur d'une deuxième tension Zener.

Dans ce cas, c'est-à-dire lorsque le dispositif électronique est configuré selon la deuxième configuration, la grille du deuxième transistor HEMT peut être directement reliée électriquement à la source du deuxième transistor HEMT et le deuxième transistor HEMT peut être du type à enrichissement. Ainsi, la valeur de la tension V_{GS2} entre la grille et la source du deuxième transistor HEMT est nulle et la valeur de la tension au-delà de laquelle le courant peut traverser le dispositif électronique, en polarisation directe, c'est-à-dire la deuxième tension Zener, peut être ajustée via l'ajustement de la valeur de la tension de seuil Vₜₕ₂ du deuxième transistor HEMT.

En variante, et lorsque le dispositif électronique est configuré selon la deuxième configuration, la grille du deuxième transistor HEMT peut être reliée électriquement à la source du deuxième transistor HEMT par l'intermédiaire d'une deuxième source de tension apte à appliquer une tension électrique V_{GS2} non nulle entre la grille du deuxième transistor HEMT et la source du deuxième transistor HEMT. Dans ce cas, la grille du deuxième transistor HEMT est utilisée pour décaler la valeur de la tension à partir de laquelle le deuxième transistor HEMT, et donc également le dispositif électronique, passera d'un état totalement bloqué à un état de conduction avec une très faible résistivité. Ainsi, la valeur de la tension (deuxième tension Zener) au-delà de laquelle le courant peut traverser le dispositif électronique polarisé en direct peut être réglée via l'ajustement de la valeur de la tension de seuil Vₜₕ₂ du deuxième transistor HEMT et/ou via l'ajustement *a posteriori* de la valeur de la tension V_{GS2} délivrée par la deuxième source de tension. Cette variante permet de réaliser un dispositif électronique dont le comportement correspond à celui d'une diode Zener bidirectionnelle et programmable.

En variante, le dispositif électronique peut être tel que :
- la source du premier transistor HEMT est reliée électriquement à une borne d'alimentation électrique du dispositif électronique par l'intermédiaire d'une résistance électrique,
- le drain du premier transistor HEMT est relié électriquement à un potentiel de référence,
- une entrée du dispositif électronique est reliée électriquement à la grille du premier transistor HEMT,
- une sortie du dispositif électronique est reliée électriquement à la source du premier transistor HEMT,
   et le dispositif électronique peut être apte à délivrer, entre la sortie du dispositif électronique et le potentiel de référence, une tension de sortie de valeur positive lorsqu'une valeur d'une tension d'entrée appliquée entre l'entrée du dispositif électronique et le potentiel de référence est supérieure à celle de la tension de seuil Vₜₕ du premier transistor HEMT. Dans une telle variante, le dispositif électronique correspond donc à un comparateur de tension permettant de comparer la valeur de la tension d'entrée avec la valeur de la tension de seuil Vₜₕ du premier transistor HEMT.

Le premier transistor HEMT peut comporter une première hétérostructure AlGaN/GaN, et/ou, lorsque le dispositif électronique comporte le deuxième transistor HEMT, le deuxième transistor HEMT peut comporter une deuxième hétérostructure AlGaN/GaN.

Il est également proposé un procédé de contrôle du passage d'un courant électrique au moins depuis une première extrémité d'une liaison électrique jusqu'à une deuxième extrémité de la liaison électrique, dans lequel :
- la liaison électrique est réalisée en reliant électriquement une source d'un premier transistor HEMT à la première extrémité et en reliant électriquement un drain du premier transistor HEMT à la deuxième extrémité, puis
- le premier transistor HEMT est polarisé au moins en inverse en appliquant une tension électrique V_{SD} de valeur positive entre la source du premier transistor HEMT et le drain du premier transistor HEMT ;
   et dans lequel le courant électrique passe de la première extrémité à la deuxième extrémité à travers le premier transistor HEMT lorsqu'une valeur d'une tension électrique V_{GD} entre une grille du premier transistor HEMT et le drain du premier transistor HEMT est supérieure à une valeur d'une tension de seuil Vₜₕ du premier transistor HEMT.

L'invention concerne également un procédé de contrôle du passage d'un courant électrique au moins depuis une première extrémité d'une liaison électrique jusqu'à une deuxième extrémité de la liaison électrique, dans lequel la liaison électrique est réalisée en reliant électriquement une source d'un premier transistor HEMT à la première extrémité, en reliant électriquement un drain du premier transistor HEMT à la deuxième extrémité, et en reliant électriquement une grille du premier transistor HEMT à la source du premier transistor HEMT, la liaison électrique étant configurée selon une première ou une deuxième configuration, la première configuration étant telle que :
- une source d'un deuxième transistor HEMT est reliée électriquement à la source du premier transistor HEMT,
- un drain du deuxième transistor HEMT est relié électriquement au drain du premier transistor HEMT,
- une grille du deuxième transistor HEMT est reliée électriquement à la source du deuxième transistor HEMT par l'intermédiaire d'au moins une première résistance électrique de valeur supérieure à environ 1 MΩ et est reliée électriquement au drain du deuxième transistor HEMT par l'intermédiaire d'au moins une deuxième résistance électrique de valeur supérieure à environ 1 MΩ,

- la valeur d'une tension de seuil Vₜₕ₂ du deuxième transistor HEMT est nulle,
   la deuxième configuration étant telle que :
   - la source du deuxième transistor HEMT est reliée électriquement au drain du premier transistor HEMT,
   - le drain du deuxième transistor HEMT est relié électriquement à la source du premier transistor HEMT,
   - la grille du deuxième transistor HEMT est reliée électriquement à la source du deuxième transistor HEMT,
      puis le premier transistor HEMT est polarisé au moins en inverse en appliquant une tension électrique V_{SD} de valeur positive entre la source du premier transistor HEMT et le drain du premier transistor HEMT, le courant électrique passant de la première extrémité à la deuxième extrémité à travers le premier transistor HEMT lorsqu'une valeur d'une tension électrique V_{GD} entre une grille du premier transistor HEMT et le drain du premier transistor HEMT est supérieure à une valeur d'une tension de seuil Vₜₕ du premier transistor HEMT,
      dans lequel, lorsque la liaison électrique est configurée selon la première configuration :
      - lorsque le premier transistor HEMT est polarisé en inverse, le deuxième transistor HEMT est également polarisé en inverse, ou le premier transistor HEMT et le deuxième transistor HEMT sont polarisés en direct en appliquant une tension électrique V_{SD} de valeur négative tels que le courant électrique passe dans ce cas de la deuxième extrémité à la première extrémité à travers le deuxième transistor HEMT,
         et dans lequel, lorsque la liaison électrique est configurée selon la deuxième configuration :
         - lorsque le premier transistor HEMT est polarisé en inverse, le deuxième transistor HEMT est polarisé en direct, ou le premier transistor HEMT est polarisé en direct et le deuxième transistor HEMT est polarisé en inverse en appliquant une tension électrique V_{SD} de valeur négative tels que le courant électrique passe dans ce cas de la deuxième extrémité à la première extrémité à travers le deuxième transistor HEMT lorsque la valeur d'une tension électrique V_{GD2} entre la grille du deuxième transistor HEMT et le drain du deuxième transistor HEMT est supérieure à celle d'une tension de seuil Vₜₕ₂ du deuxième transistor HEMT.

La liaison électrique est réalisée en outre en reliant électriquement la grille du premier transistor HEMT à la source du premier transistor HEMT.

Dans ce cas, la liaison électrique peut être réalisée en reliant directement la grille du premier transistor HEMT à la source du premier transistor HEMT, le premier transistor HEMT pouvant être du type à enrichissement, et le courant électrique peut passer de la première extrémité à la deuxième extrémité à travers le premier transistor HEMT lorsque la valeur de la tension électrique V_{SD} est supérieure à celle de la tension de seuil Vₜₕ du premier transistor HEMT.

En variante, la liaison électrique peut être réalisée en reliant électriquement la grille du premier transistor HEMT à la source du premier transistor HEMT par l'intermédiaire d'une première source de tension apte à appliquer une tension électrique V_{GS} non nulle entre la grille du premier transistor HEMT et la source du premier transistor HEMT, et le procédé peut comporter en outre, préalablement à la polarisation en inverse du premier transistor HEMT, l'application par la première source de tension de la tension électrique V_{GS} de valeur égale à la différence de la valeur de la tension de seuil Vₜₕ du premier transistor HEMT et d'une valeur de la tension électrique V_{SD} au-delà de laquelle le courant électrique est destiné à passer de la première extrémité à la deuxième extrémité à travers le premier transistor HEMT.

La liaison électrique peut être réalisée telle que :
- une source d'un deuxième transistor HEMT est reliée électriquement à la source du premier transistor HEMT,
- un drain du deuxième transistor HEMT est relié électriquement au drain du premier transistor HEMT,
- une grille du deuxième transistor HEMT est reliée électriquement à la source du deuxième transistor HEMT par l'intermédiaire d'au moins une première résistance électrique de valeur supérieure à environ 1 MΩ et est reliée électriquement au drain du deuxième transistor HEMT par l'intermédiaire d'au moins une deuxième résistance électrique de valeur supérieure à environ 1 MΩ,
- la valeur d'une tension de seuil Vₜₕ₂ du deuxième transistor HEMT est nulle,
   et, lorsque le premier transistor HEMT est polarisé en inverse, le deuxième transistor HEMT peut également être polarisé en inverse, ou le premier transistor HEMT et le deuxième transistor HEMT peuvent être polarisés en direct en appliquant une tension électrique V_{SD} de valeur négative telle que le courant électrique passe dans ce cas de la deuxième extrémité à la première extrémité à travers le deuxième transistor HEMT.

En variante, la liaison électrique peut être réalisée telle que :
- une source d'un deuxième transistor HEMT est reliée électriquement au drain du premier transistor HEMT,
- un drain du deuxième transistor HEMT est relié électriquement à la source du premier transistor HEMT,
- une grille du deuxième transistor HEMT est reliée électriquement à la source du deuxième transistor HEMT,
   et, lorsque le premier transistor HEMT est polarisé en inverse, le deuxième transistor HEMT est polarisé en direct, ou le premier transistor HEMT peut être polarisé en direct et le deuxième transistor HEMT peut être polarisé en inverse en appliquant une tension électrique V_{SD} de valeur négative tels que le courant électrique passe dans ce cas de la deuxième extrémité à la première extrémité à travers le deuxième transistor HEMT lorsque la valeur d'une tension électrique V_{GD2} entre la grille du deuxième transistor HEMT et le drain du deuxième transistor HEMT est supérieure à celle d'une tension de seuil Vₜₕ₂ du deuxième transistor HEMT.

Dans ce cas, c'est-à-dire lorsque la liaison électrique est configurés selon la deuxième configuration, la liaison électrique peut être réalisée en reliant directement la grille du deuxième transistor HEMT à la source du deuxième transistor HEMT, le deuxième transistor HEMT pouvant être du type à enrichissement, et le courant électrique peut passer de la deuxième extrémité à la première extrémité à travers le deuxième transistor HEMT lorsque la valeur de la tension électrique V_{SD} est inférieure à celle de la tension de seuil Vₜₕ₂ du deuxième transistor HEMT.

En variante, et lorsque la liaison électrique est configurée selon la deuxième configuration la liaison électrique peut être réalisée en reliant électriquement la grille du deuxième transistor HEMT à la source du deuxième transistor HEMT par l'intermédiaire d'une deuxième source de tension apte à appliquer une tension électrique V_{GS2} non nulle entre la grille du deuxième transistor HEMT et la source du deuxième transistor HEMT, et le procédé peut comporter en outre, préalablement à la polarisation en inverse du deuxième transistor HEMT, l'application par la deuxième source de tension de la tension électrique V_{GS2} de valeur égale à la différence de la valeur de la tension de seuil Vₜₕ₂ du deuxième transistor HEMT et d'une valeur de la tension électrique V_{SD} en-dessous de laquelle le courant électrique est destiné à passer de la deuxième extrémité à la première extrémité à travers le deuxième transistor HEMT.

Dans une autre configuration, la liaison électrique peut être réalisée telle que :
- la source du premier transistor HEMT est reliée électriquement à une borne d'alimentation électrique par l'intermédiaire d'une résistance électrique formant la première extrémité de la liaison électrique,
- le drain du premier transistor HEMT est relié électriquement à un potentiel de référence formant la deuxième extrémité de la liaison électrique,
- la grille du premier transistor HEMT est reliée électriquement à une entrée,
- la source du premier transistor HEMT est reliée électriquement à une sortie,
   le procédé pouvant comporter en outre, après la polarisation en inverse du premier transistor HEMT, l'application d'une tension d'entrée entre l'entrée et le potentiel de référence, et une tension de sortie de valeur positive peut être délivrée entre la sortie et le potentiel de référence lorsqu'une valeur de la tension d'entrée est supérieure à celle de la tension de seuil Vₜₕ du premier transistor HEMT.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif électronique, objet de la présente invention, selon un premier mode de réalisation,
- la figure 2 représente schématiquement un transistor HEMT faisant partie d'un dispositif électronique objet de la présente invention,
- la figure 3 représente schématiquement la caractéristique électrique de sortie d'un transistor HEMT,
- la figure 4 représente schématiquement un dispositif électronique, objet de la présente invention, selon un deuxième mode de réalisation,
- la figure 5 représente schématiquement un dispositif électronique, objet de la présente invention, selon un troisième mode de réalisation,
- la figure 6 représente schématiquement un dispositif électronique, objet de la présente invention, selon un quatrième mode de réalisation,
- la figure 7 représente schématiquement un dispositif électronique, objet de la présente invention, selon un cinquième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

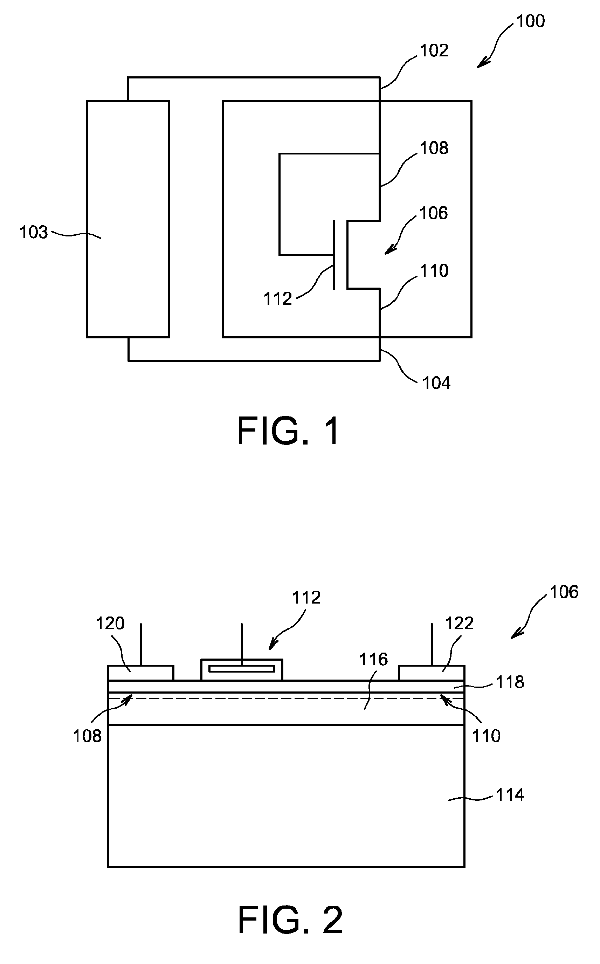

On se réfère tout d'abord à la figure 1 qui représente schématiquement un dispositif électronique 100 selon un premier mode de réalisation.

Le dispositif électronique 100 a un fonctionnement similaire à celui d'une diode Zener polarisée en inverse. Ainsi, le dispositif électronique 100 est disposé sur une liaison électrique, entre une première extrémité 102 sur laquelle un courant électrique est destiné à être appliqué, et une deuxième extrémité 104 au niveau de laquelle le courant électrique est destiné à être délivré. Le dispositif électronique 100 permet de contrôler le passage ou non du courant depuis la première extrémité 102 jusqu'à la deuxième extrémité 104 en fonction de la valeur de la tension aux bornes de ces deux extrémités 102, 104. Le dispositif électronique 100 est destiné à être passant lorsque la tension électrique entre la première extrémité 102 et la deuxième extrémité 104, appelée V₁₀₂ - V₁₀₄, correspondant à la différence entre le potentiel électrique au niveau de la première extrémité 102, appelé V₁₀₂, et le potentiel électrique au niveau de la deuxième extrémité 104, appelé V₁₀₄, est supérieure à une valeur non nulle qui sera appelée tension Zener en raison du comportement similaire du dispositif électronique 100 avec celui d'une diode Zener polarisée en inverse. De plus, lorsque le dispositif électronique 100 est passant, la valeur de la tension V₁₀₂ - V₁₀₄, est sensiblement constante quelque soit la valeur de ce courant électrique.

Pour obtenir un tel fonctionnement, le dispositif électronique 100 comporte un premier transistor HEMT 106, également appelé transistor HFET (« Heterostructure Field-Effect Transistor », ou transistor à effet de champ à hétérostructure) ou MODFET (« Modulated-Doping Field-Effect Transistor », ou transistor à effet de champ à dopage modulé), dont une source 108 est reliée électriquement à la première extrémité 102, dont un drain 110 est relié électriquement à la deuxième extrémité 104, et dont une grille 112 est reliée électriquement à la source 108. Dans ce premier mode de réalisation, la grille 112 est directement reliée à la source 108 par un fil ou une piste électrique, et le premier transistor HEMT 106 est du type à enrichissement, ou « normally off ».

Un exemple de réalisation du premier transistor HEMT 106 est représenté schématiquement sur la figure 2.

Le premier transistor HEMT 106 comporte un substrat 114, par exemple en silicium, SiC, saphir ou GaN, sur lequel est disposée une hétérojonction formée d'une couche 116 de matériau à grand gap, par exemple en GaN, et d'une couche 118 de matériau à plus grand gap, par exemple en AlGaN. Les couches 116 et 118 pourraient également être composées respectivement de GaAs et d'AlGaAs, ou d'autres matériaux de gaps adaptés à la réalisation d'une hétérostructure. Une couche tampon, non représentée sur la figure 2, est généralement présente entre le substrat 114 et la couche 116, par exemple à base d'AIN et de GaN et permettant de réaliser une adaptation cristallographique pour la croissance des couches 116 et 118 sur le substrat 114. Le premier transistor HEMT 106 comporte également un premier contact ohmique 120 en contact avec la source 108 du premier transistor HEMT 106 et un deuxième contact ohmique 122 en contact avec le drain 110 du premier transistor HEMT 106. Enfin, le premier transistor HEMT 106 comporte la grille 112 formée d'un métal et d'un diélectrique de grille dans la couche 118. En variante, il est possible d'avoir, sur la couche 118, une autre couche de GaN ou de SiN permettant de réaliser une passivation des charges surfaciques. Sur l'exemple de la figure 2, la distance entre la grille 112 et le premier contact 120 est inférieure à celle entre la grille 112 et le deuxième contact 122. Toutefois, il est possible que ces distances soient similaires l'une par rapport à l'autre.

Dans le premier transistor HEMT 106, la juxtaposition du matériau à plus grand gap de la couche 118 et du matériau à plus petit gap de la couche 116 créé une discontinuité de bande de conduction à l'interface entre les deux matériaux. Cette hétérojonction entraîne la formation d'un puits de potentiel, ou puits quantique, dans le matériau à plus petit gap où se transfèrent et s'accumulent les électrons provenant de la couche 118. L'accumulation des électrons dans ce puits est appelée gaz d'électrons bidimensionnel, ou 2DEG (« 2 Dimensional Electron Gas »), et est représentée symboliquement sur la figure 2 par des pointillés, ce gaz d'électrons étant formé entre l'interface des couches 116 et 118 et ces pointillés.

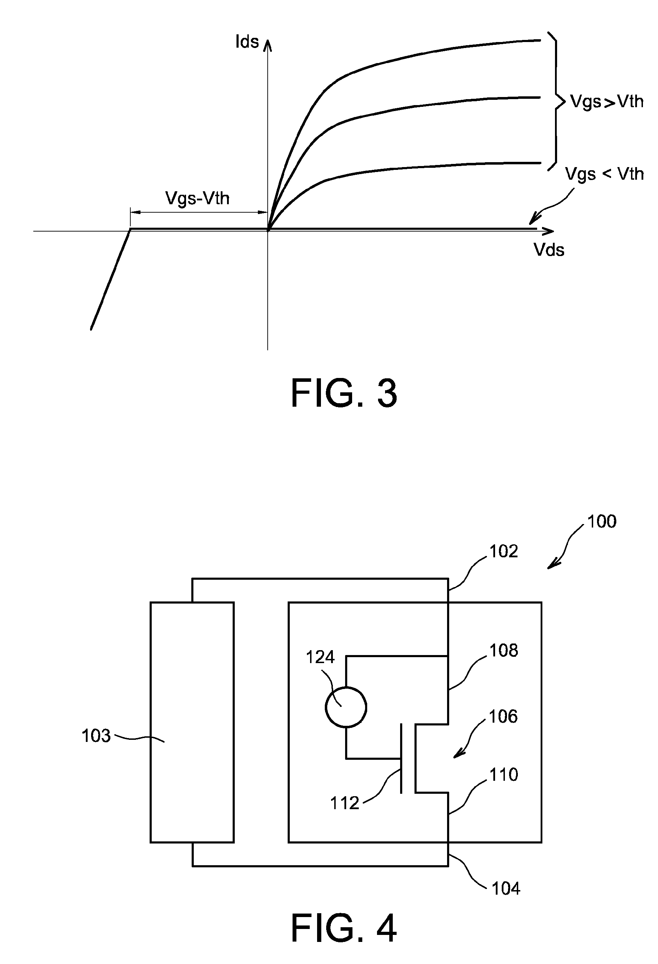

La caractéristique électrique de sortie du premier transistor HEMT 106 est représentée sur la figure 3.

Dans le premier cadran correspondant à une polarisation directe du premier transistor HEMT 106 (V_{DS} et I_{DS} positifs, Vₒₛ étant la tension entre le drain 110 et la source 108 du premier transistor HEMT 106, et I_{DS} étant le courant circulant entre le drain 110 et la source 108 du premier transistor HEMT 106), le premier transistor HEMT 106 est passant lorsque la valeur de la tension V_{GS} (tension entre la grille 112 et la source 108 du premier transistor HEMT 106) est supérieure à la valeur de la tension Vₜₕ correspondant à la tension de seuil du premier transistor HEMT 106. La valeur de cette tension de seuil Vₜₕ du premier transistor HEMT 106 dépend de différents paramètres physiques du premier transistor HEMT 106 (matériaux utilisés, dimensions des différentes couches, etc.) et est par exemple égale à environ -4V dans le cas d'un transistor HEMT à appauvrissement (ou « normally on ») ou égale à environ 2V dans le cas d'un transistor HEMT à enrichissement. Par contre, le premier transistor HEMT 106 reste bloqué lorsque V_{GS} est inférieure à Vth. Dans le dispositif électronique 100 représenté sur la figure 1, du fait que la source 108 du premier transistor HEMT 106 est reliée directement à la grille 112 du premier transistor HEMT 106 et que le premier transistor HEMT 106 est du type à enrichissement, le premier transistor HEMT 106 reste toujours bloqué dans le cas d'une polarisation directe du premier transistor HEMT 106.

Dans le troisième cadran correspondant à une polarisation inverse du premier transistor HEMT 106 (V_{DS} et I_{DS} négatifs), le premier transistor HEMT 106 est bloqué tant que V_{DS} > V_{GS} - Vₜₕ. Par contre, le premier transistor HEMT 106 devient passant lorsque V_{DS} < V_{GS} - Vₜₕ et dans ce cas, la valeur de la tension V_{DS} reste sensiblement constante quelque soit la valeur du courant I_{DS}. Le terme « sensiblement constante » est utilisé car en réalité, lorsque V_{DS} < V_{GS} - Vₜₕ, la valeur de la tension V_{DS} varie légèrement en fonction du courant I_{DS}, cette variation étant fonction d'une pente I_{DS}(V_{DS}) égale à la valeur de la résistance Ron du transistor dans le premier cadran, qui est par exemple égale à environ 10 mOhm dans le cas d'un transistor HEMT 100A/600V.

Dans le dispositif électronique 100, la grille 112 du premier transistor HEMT 106 étant reliée directement à la source 108 du premier transistor HEMT 106, la tension V_{GS} est donc toujours nulle, et le premier transistor HEMT 106 est bloqué lorsque V_{DS} > -Vₜₕ et devient passant lorsque V_{DS} < -Vₜₕ. Par exemple, si Vₜₕ = 2V, cela signifie que le dispositif électronique 100 reste bloqué lorsque la tension V₁₀₂ - V₁₀₄, qui correspond à la tension V_{SD} ou -V_{DS}, est inférieure 2V, mais que le dispositif électronique 100 devient passant lorsque la tension V_{SD} est supérieure ou égale à 2V.

La tension Zener de ce dispositif électronique 100 est donc égale à la tension de seuil Vₜₕ du premier transistor HEMT 106. La valeur de cette tension de seuil Vₜₕ du premier transistor HEMT 106 peut être ajustée lors de la réalisation du premier transistor HEMT 106 en gravant la couche 118 de matériau à plus grand gap du transistor et/ou en réalisant une implantation de charges électriques dans la couche 118. La couche 118 étant gravée totalement afin de faire disparaître le gaz 2DEG, une isolation sous la grille est alors ajoutée afin de retrouver un fonctionnement de type MOS qui nécessite alors une polarisation positive sur la grille pour « repeupler » la zone désertée par le gaz 2DEG. Des détails de réalisation d'un tel transistor HEMT sont décrits par exemple dans le document « High Voltage Normally-off GaN MOSC-HEMTs on Silicon Substrates for Power Switching Applications » de Zhongda Li et al. Proc. Int. Symp. Power Semicond. Devices ICs, pp.45-48, 2012.

Dans le dispositif électronique 100 représenté sur la figure 1, la tension de polarisation V_{SD} est délivrée par un élément 103 symbolisant l'ensemble des éléments électroniques du circuit dans lequel le dispositif électronique 100 est intégré et qui délivrent entre les extrémités 102 et 104 la tension de polarisation V_{SD}. Les moyens de polarisation du premier transistor HEMT 106 sont donc formés par les extrémités 102 et 104 et par l'élément 103.

La figure 4 représente un dispositif électronique 100 selon un deuxième mode de réalisation.

Comme dans le premier mode de réalisation, le dispositif électronique 100 selon le deuxième mode de réalisation est relié électriquement aux moyens de polarisation formés par l'élément 103, la première extrémité 102 et la deuxième extrémité 104, et comporte le premier transistor HEMT 106. Contrairement au premier mode de réalisation dans lequel la grille 112 du premier transistor HEMT 106 est reliée directement à la source 108 du premier transistor HEMT 106, la grille 112 est ici reliée électriquement à la source 108 par l'intermédiaire d'une première source de tension 124 permettant d'ajuster la tension V_{GS} appliquée entre la grille 112 et la source 108 du premier transistor HEMT 106. De plus, dans ce deuxième mode de réalisation, le premier transistor HEMT 106 peut être du type à enrichissement comme dans le premier mode de réalisation, ou du type à appauvrissement (« normally on »). Le premier transistor HEMT 106 est de préférence du type à appauvrissement en raison de la réalisation plus simple de ce type de transistor par rapport à la réalisation d'un transistor HEMT à enrichissement.

La valeur de la tension V_{GS} appliquée par la première source de tension 124 est fonction de la tension Zener souhaitée pour le dispositif électronique 100, ainsi que de la valeur de la tension de seuil Vₜₕ du premier transistor HEMT 106. Ainsi, le premier transistor HEMT 106 est bloqué tant que V_{SD} < Vₜₕ - V_{GS} et devient passant lorsque V_{SD} > Vₜₕ - V_{GS}. Dans le cas d'un premier transistor HEMT 106 à appauvrissement dont la tension de seuil Vₜₕ est par exemple égale -4V, si la tension Zener souhaitée du dispositif électronique 100 est de IV, la tension délivrée par la première source de tension 124 est choisie telle que V_{GS} = -5V (la conduction du premier transistor HEMT 106 étant dans ce cas assurée lorsque V_{SD} > Vₜₕ - V_{GS} => V_{SD} > -4 + 5 => V_{SD} > 1V). Dans le cas d'un premier transistor HEMT 106 à enrichissement dont la tension de seuil Vₜₕ est par exemple égale à 2V, si la tension Zener souhaitée du dispositif électronique 100 est de 3V, la tension délivrée par la première source de tension 124 est choisie telle que V_{GS} = -1V (la conduction du premier transistor HEMT 106 étant dans ce cas assurée lorsque V_{SD} > Vₜₕ - V_{GS} => V_{SD} > 2 + 1 => V_{SD} > 3V).

Ainsi, le dispositif électronique 100 selon ce deuxième mode de réalisation présente un fonctionnement analogue à celui d'une diode Zener polarisée en inverse dont la tension Zener est programmable et par exemple comprise entre environ - 8V et 6V avec une tension de seuil Vₜₕ par exemple comprise entre -10V et 10V (les valeurs maximales de V_{GS} étant liées à la tenue en tension de la grille du transistor).

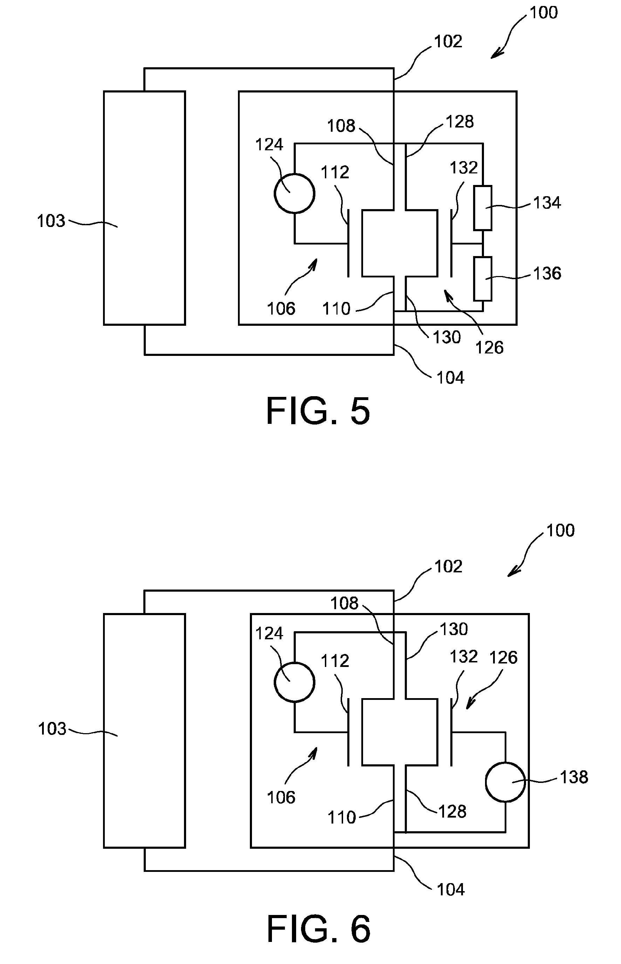

La figure 5 représente un dispositif électronique 100 selon un troisième mode de réalisation.

Comme dans le deuxième mode de réalisation, le dispositif électronique 100 est relié électriquement à la première extrémité 102, à la deuxième extrémité 104 et à l'élément 103, et comporte le premier transistor HEMT 106 et la première source de tension 124. Dans ce troisième mode de réalisation, le dispositif électronique 100 comporte également un deuxième transistor HEMT 126 dont la source 128 est reliée électriquement à la première extrémité 102 (et donc également à la source 108 du premier transistor HEMT 106) et dont le drain 130 est relié électriquement à la deuxième extrémité 104 (et donc également au drain 110 du premier transistor HEMT 106). La grille 132 du deuxième transistor HEMT 126 est reliée électriquement à la source 128 du deuxième transistor HEMT 126 par l'intermédiaire d'une première résistance électrique 134 et est reliée électriquement au drain 130 du deuxième transistor HEMT 126 par l'intermédiaire d'une deuxième résistance électrique 136. Les valeurs de la première et de la deuxième résistance électrique 134, 136 sont supérieures à environ 1 MΩ, et par exemple comprises entre environ 1 MΩ et 10 MΩ. Le deuxième transistor HEMT 126 est réalisé tel que sa tension de seuil Vₜₕ₂ soit supérieure à 0V. Comme précédemment décrit, la valeur de cette tension de seuil Vₜₕ₂ du deuxième transistor HEMT 126 peut être définie lors de la réalisation du deuxième transistor HEMT 126 par exemple en gravant la couche de matériau à plus grand gap du transistor HEMT.

Lorsque les transistors HEMT 106 et 126 sont polarisés en inverse (tension V_{SD} positive entre la source et le drain des deux transistors HEMT 106 et 126, c'est-à-dire tel qu'un courant d'entrée est appliqué sur le dispositif 100 depuis la première extrémité 102), le fonctionnement du dispositif électronique 100 selon ce troisième mode de réalisation est similaire à celui du dispositif électronique 100 selon le deuxième mode de réalisation, ce courant traversant alors le premier transistor HEMT 106 pour atteindre la deuxième extrémité 104 lorsque la tension V_{SD} aux bornes du premier transistor HEMT 106 est supérieure à la tension Zener définie pour le dispositif électronique 100 (fonction de Vₜₕ et de V_{GS}). Le deuxième transistor HEMT 126 est dans ce cas bloqué car les deux résistances électriques 134 et 136 sont telles que V_{GD} < Vₜₕ₂, c'est-à-dire V_{GS} < Vₜₕ₂ - V_{SD}. Par exemple, si V_{SD} = 1V et Vₜₕ₂ = 2V, les valeurs des deux résistances électriques peuvent être choisies telles que V_{GD} = -0,5V afin de respecter la condition V_{GS} < 1V. En outre, les deux résistances électriques 134 et 136 formant un pont diviseur de tension, la relation V_{GD} < V_{SD} est toujours respectée.

Par contre, lorsque les transistors HEMT 106 et 126 sont polarisés en direct avec une tension V_{SD} de valeur négative (ce qui revient à avoir un courant d'entrée positif sur la deuxième extrémité 104), la tension V_{GS2} entre la grille 132 et la source 128 du deuxième transistor HEMT 126 est dans ce cas supérieure à 0, et donc supérieure à sa tension de seuil Vₜₕ₂ qui est nulle, ce qui permet au courant de traverser le dispositif électronique 100 depuis la deuxième extrémité 104 jusqu'à la première extrémité 102 à travers le deuxième transistor HEMT 126 qui est dans ce cas passant.

Comme dans le deuxième mode de réalisation, le premier transistor HEMT 106 peut être du type à enrichissement ou à appauvrissement. Le deuxième transistor HEMT 126 est du type à enrichissement.

En variante de ce troisième mode de réalisation, la liaison électrique entre la grille 112 et la source 108 du transistor HEMT 106 peut ne pas comporter la première source de tension 124 mais être réalisée directement par un fil ou une piste électrique, comme précédemment décrit en liaison avec la figure 1 pour le premier mode de réalisation. Dans ce cas, la valeur de la tension Zener au-delà de laquelle le courant traverse le dispositif électronique 100 depuis la extrémité 102 jusqu'à la deuxième extrémité 104 dépend uniquement de la valeur de la tension de seuil Vₜₕ du premier transistor HEMT 106 qui est dans ce cas du type à enrichissement.

La figure 6 représente un dispositif électronique 100 selon un quatrième mode de réalisation.

Comme dans le deuxième mode de réalisation, le dispositif électronique 100 est relié électriquement à la première extrémité 102, à la deuxième extrémité 104 et à l'élément 103, et comporte le premier transistor HEMT 106 et la première source de tension 124. Dans ce quatrième mode de réalisation, le dispositif électronique 100 comporte également le deuxième transistor HEMT 126 dont la source 128 est reliée électriquement à la deuxième extrémité 104 (et donc également au drain 110 du premier transistor HEMT 106) et dont le drain 130 est relié électriquement à la première extrémité 102 (et donc également à la source 108 du premier transistor HEMT 106). Les deux transistors HEMT 106 et 126 sont donc reliés électriquement tête-bêche l'un par rapport à l'autre. La grille 132 du deuxième transistor HEMT 126 est reliée électriquement à la source 128 du deuxième transistor HEMT 126 par l'intermédiaire d'une deuxième source de tension 138 permettant d'ajuster la tension V_{GS2} appliquée entre la grille 132 et la source 128 du deuxième transistor HEMT 126.

Lorsqu'un courant d'entrée est appliqué sur la première extrémité 102, c'est-à-dire lorsque la tension V_{SD} est positive, polarisant le premier transistor HEMT 106 en inverse et polarisant le deuxième transistor HEMT 126 en direct, le fonctionnement du dispositif électronique 100 selon ce quatrième mode de réalisation est similaire à celui du dispositif électronique 100 selon le deuxième mode de réalisation, ce courant traversant alors le premier transistor HEMT 106 pour atteindre la deuxième extrémité 104 lorsque la tension V_{SD} entre la source 108 et le drain 110 du premier transistor HEMT 106 est supérieure à une première tension Zener définie pour le dispositif électronique 100, la valeur de cette première tension Zener étant fonction des valeurs de la tension V_{GS} appliquée par la première source de tension 124 et de la tension seuil Vₜₕ du premier transistor HEMT 106. Le deuxième transistor HEMT 126 étant dans ce cas polarisé en direct, il faut s'assurer que V_{GS2} < Vₜₕ₂. Par contre, lorsqu'un courant inverse est appliqué sur le dispositif électronique 100 selon ce quatrième mode de réalisation, c'est-à-dire lorsque le premier transistor HEMT 106 est polarisé en direct et le deuxième transistor HEMT 126 est polarisé en inverse (ce qui revient à appliquer un courant d'entrée positif sur le dispositif depuis la deuxième extrémité 104), ce courant traverse alors le deuxième transistor HEMT 126 depuis la deuxième extrémité 104 jusqu'à la première extrémité 102 lorsque la tension V_{SD}, qui correspond à la tension entre la source 108 et le drain 110 du premier transistor HEMT 106 mais également à la tension entre le drain 130 et la source 128 du deuxième transistor HEMT 126, qui est négative et inférieure à une deuxième tension Zener définie pour le dispositif électronique 100, la valeur de cette deuxième tension Zener étant fonction des valeurs de la tension V_{GS2} appliquée par la deuxième source de tension 138 et de la tension seuil Vₜₕ₂ du deuxième transistor HEMT 126.

Le dispositif électronique 100 selon ce quatrième mode de réalisation présente donc un comportement analogue à celui d'une diode Zener bidirectionnelle, c'est-à-dire le comportement de deux diodes Zener reliées en série l'une à l'autre au niveau de l'anode de l'une des diodes Zener et de la cathode de l'autre des diodes Zener, et programmable.

En variante, la liaison électrique entre la source 108 et la grille 112 du premier transistor HEMT 106 formée par la première source de tension 124 peut être remplacée par une liaison électrique directe formée par un fil ou une piste électrique, comme précédemment décrit en liaison avec la figure 1 pour le premier mode de réalisation. Dans ce cas, la valeur de la première tension Zener au-delà de laquelle le courant traverse le dispositif électronique 100 depuis la première extrémité 102 jusqu'à la deuxième extrémité 104 dépend uniquement de la valeur de la tension de seuil Vₜₕ du premier transistor HEMT 106 qui est dans ce cas du type à enrichissement. En outre, il est également possible que la liaison électrique entre la source 128 et la grille 132 du deuxième transistor HEMT 126 formée par la deuxième source de tension 138 puisse être remplacée par une liaison électrique directe formée par un fil ou une piste électrique. Dans ce cas, la valeur de la deuxième tension Zener au-delà de laquelle le courant traverse le dispositif électronique 100 depuis la deuxième extrémité 104 jusqu'à la première extrémité 102 dépend uniquement de la valeur de la tension de seuil Vₜₕ₂ du deuxième transistor HEMT 126 qui est dans ce cas du type à enrichissement.

Dans les modes de réalisation précédemment décrits, le ou les transistors HEMT 106, 126 sont détournés de leur fonctionnement habituel grâce à la polarisation inverse de ce ou ces transistors HEMT 106, 126. Le dispositif électronique 100 comporte donc des moyens de polarisation 102, 103 et 104 permettant de polariser en inverse le ou les transistors HEMT du dispositif électronique via l'application d'une tension V_{SD} positive entre la source et le drain du ou des transistors HEMT.

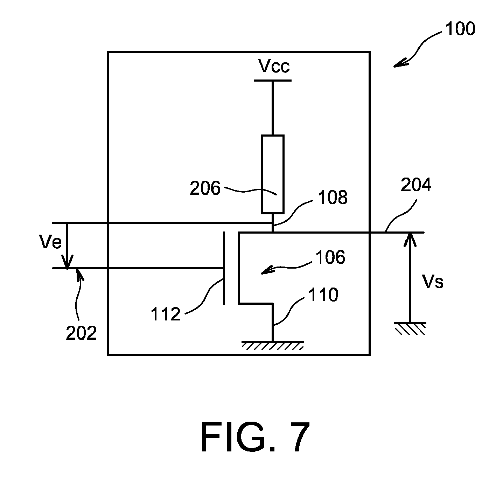

La figure 7 représente schématiquement un dispositif électronique 100 selon un cinquième mode de réalisation. Contrairement aux précédents modes de réalisation dans lesquels le dispositif électronique 100 a pour but de commander la conductivité de la liaison électrique entre la première extrémité 102 et la deuxième extrémité 104, le dispositif électronique 100 selon ce cinquième mode de réalisation correspond à un comparateur de tension permettant de comparer la valeur d'une tension appliquée en entrée du dispositif électronique 100 avec une tension Zener de ce dispositif électronique 100, et de délivrer en sortie une certaine tension lorsque cette tension appliqué en entrée du dispositif électronique 100 est supérieure à la tension Zener du dispositif électronique 100.

Le dispositif électronique 100 comporte le premier transistor HEMT 106 dont la grille 112 et la source 108 sont reliées électriquement à une entrée 202 du dispositif électronique 100 permettant l'application d'une tension d'entrée Ve entre la grille 112 et la source 108, et dont la source 108 est reliée électriquement à une sortie 204 du dispositif électronique 100. Le drain 110 du premier transistor HEMT 106 est relié électriquement à un potentiel de référence, correspondant par exemple à une masse du dispositif électronique 100. La source 108 est également reliée à une première borne d'une résistance électrique 206. Une tension d'alimentation Vcc est appliquée à une deuxième borne de la résistance électrique 206. Les moyens de polarisation en inverse du premier transistor HEMT 106 correspondent ici à la tension d'alimentation Vcc, au potentiel de référence et à la résistance 206 permettant l'application d'une tension V_{SD} positive aux bornes du premier transistor HEMT 106.

Du fait que le premier transistor HEMT 106 est passant lorsque V_{GS} > Vₜₕ, celui-ci est donc passant lorsque la tension d'entrée Ve est supérieure à la tension de seuil Vₜₕ du transistor HEMT 106 car Ve = V_{GS}. Ainsi, tant que la valeur de la tension d'entrée Ve est inférieure à la tension de seuil Vₜₕ du premier transistor HEMT 106, une tension de sortie Vs mesurée sur la sortie 204 est nulle. Lorsque la valeur de la tension d'entrée Ve devient supérieure à la tension de seuil Vₜₕ du premier transistor HEMT 106, la tension de sortie Vs devient non nulle et sensiblement égale à la valeur de la tension de seuil Vₜₕ du premier transistor HEMT 106. En outre, il est possible de régler la tension de comparaison en ajoutant une source de tension entre la grille 112 et la source 108 du premier transistor HEMT 106.

## Revendications

1. Dispositif électronique (100) comportant au moins :
- un premier transistor HEMT (106) et un deuxième transistor HEMT (126),
- des moyens de polarisation (102, 103, 104, 206) aptes à polariser au moins en inverse le premier transistor HEMT (106) en appliquant une tension électrique V_{SD} de valeur positive entre une source (108) du premier transistor HEMT (106) et un drain (110) du premier transistor HEMT (106),
dans lequel :
- le premier transistor HEMT (106) est apte à être passant lorsqu'une valeur d'une tension électrique V_{GD} entre une grille (112) du premier transistor HEMT (106) et le drain (110) du premier transistor HEMT (106) est supérieure à une valeur d'une tension de seuil Vₜₕ du premier transistor HEMT (106),
- la grille (112) du premier transistor HEMT (106) est reliée électriquement à la source (108) du premier transistor HEMT (106),
le dispositif électronique (100) étant configuré selon une première ou une deuxième configuration, la première configuration étant telle que :
- une source (128) du deuxième transistor HEMT (126) est reliée électriquement à la source (108) du premier transistor HEMT (106),
- un drain (130) du deuxième transistor HEMT (126) est relié électriquement au drain (110) du premier transistor HEMT (106),
- une grille (132) du deuxième transistor HEMT (126) est reliée électriquement à la source (128) du deuxième transistor HEMT (126) par l'intermédiaire d'au moins une première résistance électrique (134) de valeur supérieure à environ 1 MΩ et est reliée électriquement au drain (130) du deuxième transistor HEMT (126) par l'intermédiaire d'au moins une deuxième résistance électrique (136) de valeur supérieure à environ 1 MΩ,
- une valeur d'une tension de seuil Vₜₕ₂ du deuxième transistor HEMT (126) est nulle,
- les moyens de polarisation (102, 103, 104) sont également aptes à polariser en direct le premier transistor HEMT (106) et le deuxième transistor HEMT (126) en appliquant une tension électrique V_{SD} de valeur négative,
la deuxième configuration étant telle que :
- la source (128) du deuxième transistor HEMT (126) est reliée électriquement au drain (110) du premier transistor HEMT (106),
- le drain (130) du deuxième transistor HEMT (126) est relié électriquement à la source (108) du premier transistor HEMT (106),
- la grille (132) du deuxième transistor HEMT (126) est reliée électriquement à la source (128) du deuxième transistor HEMT (126),
- le deuxième transistor HEMT (126) est apte à être passant lorsque la valeur d'une tension électrique V_{GD2} entre la grille (132) du deuxième transistor HEMT (126) et le drain (130) du deuxième transistor HEMT (126) est supérieure à celle d'une tension de seuil Vₜₕ₂ du deuxième transistor HEMT (126).

2. Dispositif électronique (100) selon la revendication 1, dans lequel :
- la grille (112) du premier transistor HEMT (106) est directement reliée électriquement à la source (108) du premier transistor HEMT (106) et le premier transistor HEMT (106) est du type à enrichissement, ou
- la grille (112) du premier transistor HEMT (106) est reliée électriquement à la source (108) du premier transistor HEMT (106) par l'intermédiaire d'une première source de tension (124) apte à appliquer une tension électrique V_{GS} de valeur non nulle entre la grille (112) du premier transistor HEMT (106) et la source (108) du premier transistor HEMT (106).

3. Dispositif électronique (100) selon l'une des revendications précédentes, dans lequel, lorsque le dispositif électronique (100) est configuré selon la deuxième configuration :
- la grille (132) du deuxième transistor HEMT (126) est directement reliée électriquement à la source (128) du deuxième transistor HEMT (126) et le deuxième transistor HEMT (126) est du type à enrichissement, ou
- la grille (132) du deuxième transistor HEMT (126) est reliée électriquement à la source (128) du deuxième transistor HEMT (126) par l'intermédiaire d'une deuxième source de tension (138) apte à appliquer une tension électrique V_{GS2} non nulle entre la grille (132) du deuxième transistor HEMT (126) et la source (128) du deuxième transistor HEMT (126).

4. Dispositif électronique (100) selon l'une des revendications précédentes, dans lequel le premier transistor HEMT (106) comporte une première hétérostructure AlGaN/GaN (116, 118), et/ou dans lequel le deuxième transistor HEMT (126) comporte une deuxième hétérostructure AlGaN/GaN.

5. Procédé de contrôle du passage d'un courant électrique au moins depuis une première extrémité (102) d'une liaison électrique jusqu'à une deuxième extrémité (104) de la liaison électrique, dans lequel la liaison électrique est réalisée en reliant électriquement une source (108) d'un premier transistor HEMT (106) à la première extrémité (102), en reliant électriquement un drain (110) du premier transistor HEMT (106) à la deuxième extrémité (104), et en reliant électriquement une grille (112) du premier transistor HEMT (106) à la source (108) du premier transistor HEMT (106), la liaison électrique étant configurée selon une première ou une deuxième configuration, la première configuration étant telle que :
- une source (128) d'un deuxième transistor HEMT (126) est reliée électriquement à la source (108) du premier transistor HEMT (106),
- un drain (130) du deuxième transistor HEMT (126) est relié électriquement au drain (110) du premier transistor HEMT (106),
- une grille (132) du deuxième transistor HEMT (126) est reliée électriquement à la source (128) du deuxième transistor HEMT (126) par l'intermédiaire d'au moins une première résistance électrique (134) de valeur supérieure à environ 1 MΩ et est reliée électriquement au drain (130) du deuxième transistor HEMT (126) par l'intermédiaire d'au moins une deuxième résistance électrique (136) de valeur supérieure à environ 1 MΩ,
- la valeur d'une tension de seuil Vₜₕ₂ du deuxième transistor HEMT (126) est nulle,
la deuxième configuration étant telle que :
- la source (128) du deuxième transistor HEMT (126) est reliée électriquement au drain (110) du premier transistor HEMT (106),
- le drain (130) du deuxième transistor HEMT (126) est relié électriquement à la source (108) du premier transistor HEMT (106),
- la grille (132) du deuxième transistor HEMT (126) est reliée électriquement à la source (128) du deuxième transistor HEMT (126),
puis le premier transistor HEMT (106) est polarisé au moins en inverse en appliquant une tension électrique V_{SD} de valeur positive entre la source (108) du premier transistor HEMT (106) et le drain (110) du premier transistor HEMT (106), le courant électrique passant de la première extrémité (102) à la deuxième extrémité (104) à travers le premier transistor HEMT (106) lorsqu'une valeur d'une tension électrique V_{GD} entre une grille (112) du premier transistor HEMT (106) et le drain (110) du premier transistor HEMT (106) est supérieure à une valeur d'une tension de seuil Vₜₕ du premier transistor HEMT (106),
dans lequel, lorsque la liaison électrique est configurée selon la première configuration :
- lorsque le premier transistor HEMT (106) est polarisé en inverse, le deuxième transistor HEMT (126) est également polarisé en inverse, ou le premier transistor HEMT (106) et le deuxième transistor HEMT (126) sont polarisés en direct en appliquant une tension électrique V_{SD} de valeur négative tels que le courant électrique passe dans ce cas de la deuxième extrémité (104) à la première extrémité (102) à travers le deuxième transistor HEMT (126),
et dans lequel, lorsque la liaison électrique est configurée selon la deuxième configuration :
- lorsque le premier transistor HEMT (106) est polarisé en inverse, le deuxième transistor HEMT (126) est polarisé en direct, ou le premier transistor HEMT (106) est polarisé en direct et le deuxième transistor HEMT (126) est polarisé en inverse en appliquant une tension électrique V_{SD} de valeur négative tels que le courant électrique passe dans ce cas de la deuxième extrémité (104) à la première extrémité (102) à travers le deuxième transistor HEMT (126) lorsque la valeur d'une tension électrique V_{GD2} entre la grille (132) du deuxième transistor HEMT (126) et le drain (130) du deuxième transistor HEMT (126) est supérieure à celle d'une tension de seuil Vₜₕ₂ du deuxième transistor HEMT (126).

6. Procédé selon la revendication 5, dans lequel la liaison électrique est réalisée en reliant directement la grille (112) du premier transistor HEMT (106) à la source (108) du premier transistor HEMT (106), le premier transistor HEMT (106) étant du type à enrichissement, et dans lequel le courant électrique passe de la première extrémité (102) à la deuxième extrémité (104) à travers le premier transistor HEMT (106) lorsque la valeur de la tension électrique V_{SD} est supérieure à celle de la tension de seuil Vₜₕ du premier transistor HEMT (106).

7. Procédé selon la revendication 5, dans lequel la liaison électrique est réalisée en reliant électriquement la grille (112) du premier transistor HEMT (106) à la source (108) du premier transistor HEMT (106) par l'intermédiaire d'une première source de tension (124) apte à appliquer une tension électrique V_{GS} non nulle entre la grille (112) du premier transistor HEMT (106) et la source (108) du premier transistor HEMT (106), et comportant en outre, préalablement à la polarisation en inverse du premier transistor HEMT (106), l'application par la première source de tension (124) de la tension électrique V_{GS} de valeur égale à la différence de la valeur de la tension de seuil Vₜₕ du premier transistor HEMT (106) et d'une valeur de la tension électrique V_{SD} au-delà de laquelle le courant électrique est destiné à passer de la première extrémité (102) à la deuxième extrémité (104) à travers le premier transistor HEMT (106).

8. Procédé selon l'une des revendications 5 à 7, dans lequel, lorsque la liaison électrique est configurée selon la deuxième configuration, la liaison électrique est réalisée en reliant directement la grille (132) du deuxième transistor HEMT (126) à la source (128) du deuxième transistor HEMT (126), le deuxième transistor HEMT (126) étant du type à enrichissement, et dans lequel le courant électrique passe de la deuxième extrémité (104) à la première extrémité (102) à travers le deuxième transistor HEMT (126) lorsque la valeur de la tension électrique V_{SD} est inférieure à celle de la tension de seuil Vₜₕ₂ du deuxième transistor HEMT (126).

9. Procédé selon l'une des revendications 5 à 7, dans lequel, lorsque la liaison électrique est configurée selon la deuxième configuration, la liaison électrique est réalisée en reliant électriquement la grille (132) du deuxième transistor HEMT (126) à la source (128) du deuxième transistor HEMT (126) par l'intermédiaire d'une deuxième source de tension (138) apte à appliquer une tension électrique V_{GS2} non nulle entre la grille (132) du deuxième transistor HEMT (126) et la source (128) du deuxième transistor HEMT (126), et comportant en outre, préalablement à la polarisation en inverse du deuxième transistor HEMT (126), l'application par la deuxième source de tension (138) de la tension électrique V_{GS2} de valeur égale à la différence de la valeur de la tension de seuil Vₜₕ₂ du deuxième transistor HEMT (126) et d'une valeur de la tension électrique V_{SD} en-dessous de laquelle le courant électrique est destiné à passer de la deuxième extrémité (104) à la première extrémité (102) à travers le deuxième transistor HEMT (126).

## Patentansprüche

1. Elektronische Vorrichtung (100), zumindest enthaltend:
- einen ersten HEMT-Transistor (106) und einen zweiten HEMT-Transistor (126),
- Vorspannmittel (102, 103, 104, 206), die dazu geeignet sind, den ersten HEMT-Transistor (106) zumindest in Sperrrichtung vorzuspannen, indem eine elektrische Spannung V_{SD} mit positivem Wert zwischen einer Source (108) des ersten HEMT-Transistors (106) und einem Drain (110) des ersten HEMT-Transistors (106) angelegt wird,
wobei
- der erste HEMT-Transistor (106) dazu geeignet ist, dann leitend zu sein, wenn ein Wert einer elektrischen Spannung V_{GD} zwischen einem Gate (112) des ersten HEMT-Transistors (106) und dem Drain (110) des ersten HEMT-Transistors (106) höher als ein Wert einer elektrischen Spannungsschwelle Vₜₕ des ersten HEMT-Transistors (106) ist,
- das Gate (112) des ersten HEMT-Transistors (106) elektrisch mit der Source (108) des ersten HEMT-Transistors (106) verbunden ist,
wobei die elektronische Vorrichtung (100) nach einer ersten oder einer zweiten Konfiguration konfiguriert ist, wobei die erste Konfiguration derart ist, dass:
- eine Source (128) des zweiten HEMT-Transistors (126) elektrisch mit der Source (108) des ersten HEMT-Transistors (106) verbunden ist,
- ein Drain (130) des zweiten HEMT-Transistors (126) elektrisch mit dem Drain (110) des ersten HEMT-Transistors (106) verbunden ist,
- ein Gate (132) des zweiten HEMT-Transistors (126) elektrisch mit der Source (128) des zweiten HEMT-Transistors (126) über zumindest einen ersten elektrischen Widerstand (134) mit einem Wert höher als etwa 1 MΩ verbunden ist und elektrisch mit dem Drain (130) des zweiten HEMT-Transistors (126) über zumindest einen zweiten elektrischen Widerstand (136) mit einem Wert höher als etwa 1 MΩ verbunden ist,
- ein Wert einer Spannungsschwelle Vₜₕ₂ des zweiten HEMT-Transistors (126) null beträgt,
- die Vorspannmittel (102, 103, 104) auch dazu geeignet sind, den ersten HEMT-Transistor (106) und den zweiten HEMT-Transistor (126) in Durchlassrichtung vorzuspannen, indem eine elektrische Spannung V_{SD} mit negativem Wert angelegt wird,
wobei die zweite Konfiguration derart ist, dass:
- die Source (128) des zweiten HEMT-Transistors (126) elektrisch mit dem Drain (110) des ersten HEMT-Transistors (106) verbunden ist,
- der Drain (130) des zweiten HEMT-Transistors (126) elektrisch mit der Source (108) des ersten HEMT-Transistors (106) verbunden ist,
- das Gate (132) des zweiten HEMT-Transistors (126) elektrisch mit der Source (128) des zweiten HEMT-Transistors verbunden ist,
- der zweite HEMT-Transistor (126) dazu geeignet ist, dann leitend zu sein, wenn der Wert einer elektrischen Spannung V_{GD2} zwischen dem Gate (132) des zweiten HEMT-Transistors (126) und dem Drain (130) des zweiten HEMT-Transistors (126) höher als der einer Spannungsschwelle Vₜₕ₂ des zweiten HEMT-Transistors (126) ist.

2. Elektronische Vorrichtung (100) nach Anspruch 1, wobei
- das Gate (112) des ersten HEMT-Transistors (106) elektrisch direkt mit der Source (108) des ersten HEMT-Transistors (106) verbunden ist und der erste HEMT-Transistor (106) vom Anreicherungstyp ist, oder
- das Gate (112) des ersten HEMT-Transistors (106) elektrisch mit der Source (108) des ersten HEMT-Transistors (106) über eine erste Spannungsquelle (124) verbunden ist, die dazu geeignet ist, eine elektrische Spannung V_{GS} mit einem Wert ungleich null zwischen dem Gate (112) des ersten HEMT-Transistors (106) und der Source (108) des ersten HEMT-Transistors (106) anzulegen.

3. Elektronische Vorrichtung (100) nach einem der vorangehenden Ansprüche, wobei dann, wenn die elektronische Vorrichtung (100) nach der zweiten Konfiguration konfiguriert ist,
- das Gate (132) des zweiten HEMT-Transistors (126) elektrisch direkt mit der Source (128) des zweiten HEMT-Transistors (126) verbunden ist und der zweite HEMT-Transistor (126) vom Anreicherungstyp ist, oder
- das Gate (132) des zweiten HEMT-Transistors (126) elektrisch mit der Source (128) des zweiten HEMT-Transistors (126) über eine zweite Spannungsquelle (138) verbunden ist, die dazu geeignet ist, eine elektrische Spannung V_{GS2} ungleich null zwischen dem Gate (132) des zweiten HEMT-Transistors (126) und der Source (128) des zweiten HEMT-Transistors (126) anzulegen.

4. Elektronische Vorrichtung (100) nach einem der vorangehenden Ansprüche, wobei der erste HEMT-Transistor (106) eine erste Heterostruktur AlGaN/GaN (116, 118) enthält und/oder der zweite HEMT-Transistor (126) eine zweite Heterostruktur AlGaN/GaN enthält.

5. Verfahren zum Kontrollieren des Durchgangs eines elektrischen Stroms zumindest von einem ersten Ende (102) einer elektrischen Verbindung bis zu einem zweiten Ende (104) der elektrischen Verbindung, wobei die elektrische Verbindung hergestellt wird, indem eine Source (108) eines ersten HEMT-Transistors (106) mit dem ersten Ende (102) elektrisch verbunden wird, indem ein Drain (110) des ersten HEMT-Transistors (106) elektrisch mit dem zweiten Ende (104) verbunden wird und indem ein Gate (112) des ersten HEMT-Transistors (106) elektrisch mit der Source (108) des ersten HEMT-Transistors (106) verbunden wird, wobei die elektrische Verbindung nach einer ersten oder einer zweiten Konfiguration konfiguriert ist, wobei die erste Konfiguration derart ist, dass
- eine Source (128) eines zweiten HEMT-Transistors (126) elektrisch mit der Source (108) des ersten HEMT-Transistors (106) verbunden ist,
- ein Drain (130) des zweiten HEMT-Transistors (126) elektrisch mit dem Drain (110) des ersten HEMT-Transistors (106) verbunden ist,
- ein Gate (132) des zweiten HEMT-Transistors (126) elektrisch mit der Source (128) des zweiten HEMT-Transistors (126) über zumindest einen ersten elektrischen Widerstand (134) mit einem Wert höher als etwa 1 MΩ verbunden ist und elektrisch mit dem Drain (130) des zweiten HEMT-Transistors (126) über zumindest einen zweiten elektrischen Widerstand (136) mit einem Wert höher als etwa 1 MΩ verbunden ist,
- der Wert einer Spannungsschwelle Vₜₕ₂ des zweiten HEMT-Transistors (126) null beträgt,
wobei die zweite Konfiguration derart ist, dass
- die Source (128) des zweiten HEMT-Transistors (126) elektrisch mit dem Drain (110) des ersten HEMT-Transistors (106) verbunden ist,
- der Drain (130) des zweiten HEMT-Transistors (126) elektrisch mit der Source (108) des ersten HEMT-Transistors (106) verbunden ist,
- das Gate (132) des zweiten HEMT-Transistors (126) elektrisch mit der Source (128) des zweiten HEMT-Transistors (126) verbunden ist,
wonach der erste HEMT-Transistor (106) zumindest in Sperrrichtung vorgespannt wird, indem eine elektrische Spannung V_{SD} mit positivem Wert zwischen der Source (108) des ersten HEMT-Transistors (106) und dem Drain (110) des ersten HEMT-Transistors (106) angelegt wird, wobei der elektrische Strom von dem ersten Ende (102) zum zweiten Ende (104) durch den ersten HEMT-Transistor (106) dann fließt, wenn ein Wert einer elektrischen Spannung V_{GD} zwischen einem Gate (112) des ersten HEMT-Transistors (106) und dem Drain (110) des ersten HEMT-Transistors (106) höher als ein Wert einer Spannungsschwelle Vₜₕ des ersten HEMT-Transistors (106) ist,
wobei dann, wenn die elektrische Verbindung nach der ersten Konfiguration konfiguriert ist,
- wenn der erste HEMT-Transistor (106) in Sperrrichtung vorgespannt wird, der zweite HEMT-Transistor (126) auch in Sperrrichtung vorgespannt wird, oder der erste HEMT-Transistor (106) und der zweite HEMT-Transistor (126) leitend vorgespannt werden, indem eine elektrische Spannung V_{SD} mit negativem Wert angelegt wird, so dass der elektrische Strom in diesem Falle von dem zweiten Ende (104) zum ersten Ende (102) durch den zweiten HEMT-Transistor (126) fließt,
und wobei dann, wenn die elektrische Verbindung nach der zweiten Konfiguration konfiguriert ist,
- wenn der erste HEMT-Transistor (106) in Sperrrichtung vorgespannt ist, der zweite HEMT-Transistor (126) leitend vorgespannt wird, oder der erste HEMT-Transistor (106) leitend vorgespannt wird und der zweite HEMT-Transistor (126) in Sperrrichtung vorgespannt wird, indem eine elektrische Spannung V_{SD} mit negativem Wert angelegt wird, so dass der elektrische Strom in diesem Falle von dem zweiten Ende (104) zum ersten Ende (102) durch den zweiten HEMT-Transistor (126) fließt, wenn der Wert einer elektrischen Spannung V_{GD2} zwischen dem Gate (132) des zweiten HEMT-Transistors (126) und dem Drain (130) des zweiten HEMT-Transistors (126) höher als der einer Spannungsschwelle Vₜₕ₂ des zweiten HEMT-Transistors (126) ist.

6. Verfahren nach Anspruch 5, wobei die elektrische Verbindung hergestellt wird, indem das Gate (112) des ersten HEMT-Transistors (106) direkt mit der Source (108) des ersten HEMT-Transistors (106) verbunden wird, wobei der erste HEMT-Transistor (106) vom Anreicherungstyp ist, und wobei der elektrische Strom von dem ersten Ende (102) zum zweiten Ende (104) durch den ersten HEMT-Transistor (106) fließt, wenn der Wert der elektrischen Spannung V_{SD} höher als der der Spannungsschwelle Vₜₕ des ersten HEMT-Transistors (106) ist.

7. Verfahren nach Anspruch 5, wobei die elektrische Verbindung hergestellt wird, indem das Gate (112) des ersten HEMT-Transistors (106) elektrisch mit der Source (108) des ersten HEMT-Transistors (106) über eine erste Spannungsquelle (124) verbunden wird, die dazu geeignet ist, eine elektrische Spannung V_{GS} ungleich null zwischen dem Gate (112) des ersten HEMT-Transistors (106) und der Source (108) des ersten HEMT-Transistors (106) anzulegen, wobei es ferner vor der Vorspannung des ersten HEMT-Transistors (106) in Sperrrichtung das Anlegen der elektrischen Spannung V_{GS} durch die erste Spannungsquelle (124) umfasst, deren Wert gleich der Differenz zwischen dem Wert der Spannungsschwelle Vₜₕ des ersten HEMT-Transistors (106) und einem Wert der elektrischen Spannung V_{SD} ist, über den hinaus der elektrische Strom von dem ersten Ende (102) zum zweiten Ende (104) durch den ersten HEMT-Transistor (106) hindurch fliesen soll.

8. Verfahren nach einem der Ansprüche 5 bis 7, wobei dann, wenn die elektrische Verbindung nach der zweiten Konfiguration konfiguriert ist, die elektrische Verbindung hergestellt wird, indem das Gate (132) des zweiten HEMT-Transistors (126) direkt mit der Source (128) des zweiten HEMT-Transistors (126) verbunden wird, wobei der zweite HEMT-Transistor (126) vom Anreicherungs-Typ ist, und wobei der elektrische Strom von dem zweiten Ende (104) zum ersten Ende (102) durch den zweiten HEMT-Transistor (126) hindurch dann fliest, wenn der Wert der elektrischen Spannung V_{SD} kleiner als der der Spannungsschwelle Vₜₕ₂ des zweiten HEMT-Transistors (126) ist.

9. Verfahren nach einem der Ansprüche 5 bis 7, wobei dann, wenn die elektrische Verbindung nach der zweiten Konfiguration konfiguriert ist, die elektrische Verbindung hergestellt wird, indem das Gate (132) des zweiten HEMT-Transistors (126) elektrisch mit der Source (128) des zweiten HEMT-Transistors (126) über eine zweite Spannungsquelle (138) verbunden wird, die dazu geeignet ist, eine elektrische Spannung V_{GS2} ungleich null zwischen dem Gate (132) des zweiten HEMT-Transistors (126) und der Source (128) des zweiten HEMT-Transistors (126) anzulegen, wobei es ferner vor der Vorspannung des zweiten HEMT-Transistors (126) in Sperrrichtung das Anlegen der elektrischen Spannung V_{GS2} durch die zweite Spannungsquelle (138) umfasst, deren Wert gleich der Differenz zwischen dem Wert der Spannungsschwelle Vₜₕ₂ des zweiten HEMT-Transistors (126) und einem Wert der elektrischen Spannung V_{SD} ist, unterhalb welcher der elektrische Strom von dem zweiten Ende (104) zum ersten Ende (102) durch den zweiten HEMT-Transistor (126) hindurch fliesen soll.

## Claims

1. An electronic device (100) including at least:
- a first HEMT transistor (106) and a second HEMT transistor (126),
- bias means (102, 103, 104, 206) able to at least reverse bias the first HEMT transistor (106) by applying an electric voltage V_{SD} of a positive value between a source (108) of the first HEMT transistor (106) and a drain (110) of the first HEMT transistor (106),
wherein:
- the first HEMT transistor (106) is able to be ON when a value of an electric voltage V_{GD} between a gate (112) of the first HEMT transistor (106) and the drain (110) of the first HEMT transistor (106) is higher than a value of a threshold voltage Vₜₕ of the first HEMT transistor (106),
- the gate (112) of the first HEMT transistor (106) is electrically connected to the source (108) of the first HEMT transistor (106),
the electronic device (100) being configured according to a first configuration or a second configuration, the first configuration being such that:
- a source (128) of the second HEMT transistor (126) is electrically connected to the source (108) of the first HEMT transistor (106),
- a drain (130) of the second HEMT transistor (126) is electrically connected to the drain (110) of the first HEMT transistor (106),
- a gate (132) of the second HEMT transistor (126) is electrically connected to the source (128) of the second HEMT transistor (126) via at least one first resistor (134) of a value higher than about 1 MΩ and is electrically connected to the drain (130) of the second HEMT transistor (126) via at least one second resistor (136) of a value higher than about 1 MΩ,
- a value of a threshold voltage Vₜₕ₂ of the second HEMT transistor (126) is zero,
- the bias means (102, 103, 104) are also able to forward bias the first HEMT transistor (106) and the second HEMT transistor (126) by applying an electric voltage V_{SD} of a negative value,
the second configuration being such that:
- the source (128) of the second HEMT transistor (126) is electrically connected to the drain (110) of the first HEMT transistor (106),
- the drain (130) of the second HEMT transistor (126) is electrically connected to the source (108) of the first HEMT transistor (106),
- the gate (132) of the second HEMT transistor (126) is electrically connected to the source (128) of the second HEMT transistor (126),
- the second HEMT transistor (126) is able to be ON when the value of an electric voltage V_{GD2} between the gate (132) of the second HEMT transistor (126) and the drain (130) of the second HEMT transistor (126) is higher than that of a threshold voltage Vₜₕ₂ of the second HEMT transistor (126).

2. The electronic device (100) according to claim 1, wherein:
- the gate (112) of the first HEMT transistor (106) is directly electrically connected to the source (108) of the first HEMT transistor (106) and the first HEMT transistor (106) is of the enhancement type, or
- the gate (112) of the first HEMT transistor (106) is electrically connected to the source (108) of the first HEMT transistor (106) via a first voltage source (124) able to apply an electric voltage V_{GS} of a non-zero value between the gate (112) of the first HEMT transistor (106) and the source (108) of the first HEMT transistor (106).

3. The electronic device (100) according to one of the preceding claims, wherein, when the electronic device (100) is configured according to the second configuration:
- the gate (132) of the second HEMT transistor (126) is directly electrically connected to the source (128) of the second HEMT transistor (126) and the second HEMT transistor (126) is of the enhancement type, or
- the gate (132) of the second HEMT transistor (126) is electrically connected to the source (128) of the second HEMT transistor (126) via a second voltage source (138) able to apply a non-zero electric voltage V_{GS2} between the gate (132) of the second HEMT transistor (126) and the source (128) of the second HEMT transistor (126).

4. The electronic device (100) according to one of the preceding claims, wherein the first HEMT transistor (106) includes a first AlGaN/GaN heterostructure (116, 118), and/or wherein the second HEMT transistor (126) includes a second AlGaN/GaN heterostructure.

5. A method for controlling the flow of an electric current at least from a first end (102) of an electrical connection to a second end (104) of the electrical connection, wherein the electrical connection is made by electrically connecting a source (108) of a first HEMT transistor (106) to the first end (102), by electrically connecting a drain (110) of the first HEMT transistor (106) to the second end (104), and by electrically connecting a gate (112) of the first HEMT transistor (106) to the source (108) of the first HEMT transistor (106), the electrical connection being configured according to a first configuration or a second configuration, the first configuration being such that:
- a source (128) of a second HEMT transistor (126) is electrically connected to the source (108) of the first HEMT transistor (106),
- a drain (130) of the second HEMT transistor (126) is electrically connected to the drain (110) of the first HEMT transistor (106),
- a gate (132) of the second HEMT transistor (126) is electrically connected to the source (128) of the second HEMT transistor (126) via at least one first resistor (134) of a value higher than about 1 MΩ and is electrically connected to the drain (130) of the second HEMT transistor (126) via at least one second resistor (136) of a value higher than about 1 MΩ,
- the value of a threshold voltage Vₜₕ₂ of the second HEMT transistor (126) is zero,
the second configuration being such that:
- the source (128) of a second HEMT transistor (126) is electrically connected to the drain (110) of the first HEMT transistor (106),
- the drain (130) of the second HEMT transistor (126) is electrically connected to the source (108) of the first HEMT transistor (106),
- the gate (132) of the second HEMT transistor (126) is electrically connected to the source (128) of the second HEMT transistor (126),
then the first HEMT transistor (106) is at least reverse biased by applying an electric voltage V_{SD} of a positive value between the source (108) of the first HEMT transistor (106) and the drain (110) of the first HEMT transistor (106), the electric current flowing from the first end (102) to the second end (104) through the first HEMT transistor (106) when a value of an electric voltage V_{GD} between a gate (112) of the first HEMT transistor (106) and the drain (110) of the first HEMT transistor (106) is higher than a value of a threshold voltage Vₜₕ of the first HEMT transistor (106),
wherein, when the electrical connection is configured according to the first configuration:
- when the first HEMT transistor (106) is reverse biased, the second HEMT transistor (126) is also reverse biased, or the first HEMT transistor (106) and the second HEMT transistor (126) are forward biased by applying an electric voltage V_{SD} of a negative value such that the electric current flows in this case from the second end (104) to the first end (102) through the second HEMT transistor (126),
and wherein, when the electrical connection is configured according to the second configuration:
- when the first HEMT transistor (106) is reverse biased, the second HEMT transistor (126) is forward biased, or the first HEMT transistor (106) is forward biased and the second HEMT transistor (126) is reverse biased by applying an electric voltage V_{SD} of a negative value such that the electric current flows in this case from the second end (104) to the first end (102) through the second HEMT transistor (126) when the value of an electric voltage V_{GD2} between the gate (132) of the second HEMT transistor (126) and the drain (130) of the second HEMT transistor (126) is higher than that of a threshold voltage Vₜₕ₂ of the second HEMT transistor (126).

6. The method according to claim 5, wherein the electrical connection is made by directly connecting the gate (112) of the first HEMT transistor (106) to the source (108) of the first HEMT transistor (106), the first HEMT transistor (106) being of the enhancement type, and wherein the electric current flows from the first end (102) to the second end (104) through the first HEMT transistor (106) when the value of the electric voltage V_{SD} is higher than that of the threshold voltage Vₜₕ of the first HEMT transistor (106).

7. The method according to claim 5, wherein the electrical connection is made by electrically connecting the gate (112) of the first HEMT transistor (106) to the source (108) of the first HEMT transistor (106) via a first voltage source (124) able to apply a non-zero electric voltage V_{GS} between the gate (112) of the first HEMT transistor (106) and the source (108) of the first HEMT transistor (106), and further including, prior to the reverse bias of the first HEMT transistor (106), the first voltage source (124) applying the electric voltage V_{GS} of a value equal to the difference between the value of the threshold voltage Vₜₕ of the first HEMT transistor (106) and a value of the electric voltage V_{SD} beyond which the electric current is intended to flow from the first end (102) to the second end (104) through the first HEMT transistor (106).

8. The method according to one of previous claims 5 to 7, wherein, when the electrical connection is configured according to the second configuration, the electrical connection is made by directly connecting the gate (132) of the second HEMT transistor (126) to the source (128) of the second HEMT transistor (126), the second HEMT transistor (126) being of the enhancement type, and wherein the electric current flows from the second end (104) to the first end (102) through the second HEMT transistor (126) when the value of the electric voltage V_{SD} is lower than that of the threshold voltage Vₜₕ₂ of the second HEMT transistor (126).

9. The method according to one of previous claims 5 to 7, wherein, when the electrical connection is configured according to the second configuration, the electrical connection is made by electrically connecting the gate (132) of the second HEMT transistor (126) to the source (128) of the second HEMT transistor (126) via a second voltage source (138) able to apply a non-zero electric voltage V_{GS2} between the gate (132) of the second HEMT transistor (126) and the source (128) of the second HEMT transistor (126), and further including, prior to the reverse bias of the second HEMT transistor (126), the second voltage source (138) applying the electric voltage V_{GS2} of a value equal to the difference between the value of the threshold voltage Vₜₕ₂ of the second HEMT transistor (126) and a value of the electric voltage V_{SD} below which the electric current is intended to flow from the second end (104) to the first end (102) through the second HEMT transistor (126).
